## Europäisches Patentamt

## European Patent Office

## Office européen des brevets

(19)

(11) Numéro de publication: **0 111 611**
**B1**

(12)

# FASCICULE DE BREVET EUROPEEN

(45) Date de publication du fascicule du brevet:
**13.05.87**

(51) Int. Cl.⁴: **C 23 C 14/30, C 23 C 14/56**

(21) Numéro de dépôt: **82430032.1**

(22) Date de dépôt: **28.10.82**

(54) **Perfectionnements aux procédés et équipements de dépôt par évaporation sous vide mettant en oeuvre un canon à électrons.**

(43) Date de publication de la demande:
**27.06.84 Bulletin 84/26**

(45) Mention de la délivrance du brevet:
**13.05.87 Bulletin 87/20**

(84) Etats contractants désignés:
**DE FR GB IT**

(56) Documents cités:
IBM TECHNICAL DISCLOSURE BULLETIN; vol. 24, no. 1B, juin 1981, page 850, New York, USA W.J. SLATTERY: "E-gun source thermal stabilizer"
PATENTS ABSTRACTS OF JAPAN, vol. 6, no. 261, (C141) [1139], 21 décembre 1982 & JP - A - 57 155 377 (NIPPON DENKI K.K.) 25-09-1982
REVIEW OF SCIENTIFIC INSTRUMENTS, vol. 41, no. 3, mars 1970, pages 468-469, New York, USA H.W. KOREN et al.: "Stable electron beam evaporation of indium"
IBM TECHNICAL DISCLOSURE BULLETIN, vol. 14, no. 10, mars 1972, page 3131, New York, USA M.S. EFFRON: "Homogeneous film evaporation of differing vapor pressure materials"
IBM TECHNICAL DISCLOSURE BULLETIN, vol. 22, no. 10, mars 1980, pages 4372-4374, New York, USA J.A. CARLSON et al.: "Method for preparing solder alloy films"
IBM TECHNICAL DISCLOSURE BULLETIN; vol. 12, no. 11, avril 1970, pages 2016-2017, New York, USA W.D. RUH et al.: "Manufacturing reproducible uniform composition alloy layers containing at least two components"

(73) Titulaire: **International Business Machines Corporation, Old Orchard Road, Armonk, N.Y. 10504 (US)**
(84) Etats contractants désignés: **DE GB IT**

(73) Titulaire: **Compagnie IBM FRANCE, 5 Place Vendôme, F-75000 Paris 1er (FR)**
(84) Etats contractants désignés: **FR**

(72) Inventeur: **Bourgeois, Serge, 85 domaine de Villiers, F-91210 Draveil (FR)**
Inventeur: **Carle, Jean-François, 21 rue des Maugrenautes Servaise, F-91530 Saint Cheron (FR)**
Inventeur: **Lochon, Henri, 15 Allée du COlonel Kock Sainry/Seine, F-91100 Corbeil Essonnes (FR)**
Inventeur: **Trotin, Jean-Pierre, 4 rue du 8 mai 1945, F-91490 Milly-la-Forêt (FR)**

(74) Mandataire: **Klein, Daniel Jacques Henri, Compagnie IBM France Département de Propriété Intellectuelle, F-06610 La Gaude (FR)**

## Description

La présente invention se rapporte aux procédés et équipements de dépôt par évaporation sous vide mettant en œuvre un canon à électrons et plus particulièrement à ceux destinés à la formation des plots de soudure (Pb-Sn, Pb-In, ...) sur les microplaquettes de circuits intégrés monolithiques en silicium.

Cette étape de formation des plots de soudure est pratiquement l'étape finale du traitement des tranches semi-conductrices typiquement en silicium, avant l'étape de découpe des tranches en microplaquettes. Les tranches de silicium qui ont subi les différentes étapes de traitement (épitaxie, diffusion, oxydation, métallurgie, passivation, ...) sont prêtes à recevoir les plots de soudure.

Des ouvertures sont d'abord réalisées selon une configuration désirée dans la couche supérieure isolante des tranches puis la métallurgie de limitation, (généralement une rondelle multi-couches chrome-cuivre-or), est formée dans ces ouvertures. L'étape finale consiste donc à former des plots de soudure, typiquement des billes, à l'emplacement de ces rondelles, pour servir ultérieurement de contacts d'entrée sortie pour les microplaquettes.

Un procédé classique de formation de ces plots de soudure est décrit dans la référence US-A 3 458 925 et un perfectionnement dans l'IBM Technical Disclosure Bulletin, Vol. 22, No. 7, décembre 1979, pages 2734-35, un article intitulé: «Double Mask System for Solder Bump Formation» de P.A. Totta.

Ce procédé comporte les étapes suivantes: masquage de la surface de la tranche semiconductrice, généralement à l'aide d'un masque métallique, de manière à exposer les zones de limitation constituées par les rondelles, mais également la zone immédiatement adjacente à chacune de ces rondelles pour chaque microplaquette, évaporation sous vide, à partir d'un creuset chauffé par induction HF contenant ladite soudure, d'une mince couche de soudure à travers le masque, enlèvement du masque, chauffage de la tranche à la température de fusion de la soudure de manière qu'elle se contracte et que sa tension superficielle lui donne la forme d'une bille, et enfin refroidissement pour figer la soudure.

Ce procédé classique dit d'évaporation sous vide par creuset chauffé ou par induction HF, présente deux graves inconvénients. Ce procédé se caractérise par un chauffage dans la masse, de la source disposée dans le creuset chauffé. Il en résulte que:

1) des fluctuations de couplage entre la bobine d'induction et le creuset sont inévitables (car liées à des paramètres variés dont certains sont difficilement contrôlables: température de refroidissement de la bobine, variation de volume de la source durant l'évaporation, etc.). Ces fluctuations difficilement contrôlables ont une grande influence sur les vitesses d'évaporation qui sont jamais constantes ni reproductibles. On obtient finalement une grande disparité dans les caractéristiques des films obtenus,

2) plus grave encore est le problème des micro-projections (spitting) qui se produisent aléatoirement durant l'évaporation et causent ainsi des dépôts défectueux, une explication possible consiste à dire que l'évaporation est parfois bloquée en raison de la formation d'une membrane constituée par des composés oxydés localisés à la surface du bain en fusion, jusqu'à ce que la différence de pression entre le bain et l'enceinte à vide devienne suffisante pour briser cette membrane, ce qui produit une explosion qui projette des quantités de matériaux du bain en direction des tranches et bouche complètement ou partiellement certains des trous du masque métallique. Il en résulte finalement, soit des plots manquants, soit des plots ne présentant pas le dimensionnel désiré. Dans tous les cas, les microplaquettes présentant un seul de ces défauts sont rejetées. Généralement, quelques pourcents de la fabrication sont éliminés avant que les microplaquettes soient montées sur les modules en céramique. Une solution à ce problème consiste à réduire les vitesses de dépôt, mais il en résulte un tel accroissement des durées de cycle, que cette solution n'est pas viable industriellement.

De plus, on sait que les récents développements de la microélectronique sont basés sur une minitiarisation de plus en plus poussée des différents composants élémentaires actifs (transistors, diodes, ... ) ou passifs (résistances, ... ) et qu'ils conduisent vers une intégration à très grande échelle encore jamais atteinte.

En outre, on intègre un nombre croissant de fonctions logiques et/ou analogiques sur une même microplaquette.

Il en résulte donc un accroissement considérable du nombre de plots de soudure nécessaire sur chaque microplaquette pour assurer les échanges de signaux électriques entre la microplaquette et les circuits extérieurs. Les microplaquettes à moyenne densité d'intégration (MSI) comportaient de l'ordre de vingt plots de soudure, et celles à grande densité d'intégration (LSI), de l'ordre de la centaine. Avec l'intégration de près d'un million de composants élémentaires, on atteint le domaine de l'intégration à très grande échelle (VLSI), et le besoin de réaliser des microplaquettes comportant plusieurs centaines de plots de soudure se fait donc dores et déjà ressentir.

Or à l'évidence, le procédé classique de formation des plots par évaporation sous vide par induction HF, n'est pas en mesure de répondre à ce besoin, parce que les plots doivent présenter des dimensionnels de plus en plus fins, et parce qu'un contrôle de plus en plus serré des paramètres définissant les plots: composition et volume, devient nécessaire. Les projections mentionnées ci-dessus seraient une source trop importante de plots défectueux et conduiraient au rejet d'une quantité croissante avec le nombre de plots, de micro-plaquettes, ce qui n'est pas concevable.

La présente invention se rapporte donc à un équipement en particulier pour la formation des plots de soudure qui poursuit les objectifs suivants:

1. accroître la qualité des films déposés et fournir des résultats reproductibles (épaisseur, composition), quelque soit le matériau à déposer (Pb, Sn, In, ...) et ce pour différents lots;
2. accroître le rendement en réduisant le nombre de plots de soudure défectueux ou manquants;
3. réduire les coûts de fabrications grâce à une meilleure productivité, par des temps de cycle courts, la suppression des recharges du creuset grâce à la possibilité d'évaporer la source à fond de creuset et en conséquence l'augmentation de la durée de vie des creusets;
4. simplification de l'équipement d'évaporation sous vide.

Un équipement classique de dépôt par évaporation sous vide par canon à électrons est du genre comprenant une enceinte à vide, un dispositif porte-substrats typiquement des tranches en silicium exposées selon une configuration désirée, un creuset en forme de U ou de V tronqué contenant la source du matériau à évaporer, et un canon à électrons. Ces éléments sont connus dans la technique. On pourra se référer par exemple à l'article paru dans l'IBM TDB, Vol. 24, N° 1B, juin 1981, page 850: «E-gun source thermal stabilizer». Cet article décrit un creuset en molybdène, présentant la forme d'un V tronqué et contenant des billes de cuivre destinées à être évaporées sous l'action calorifique d'un faisceau d'électrons émis par un canon à électrons. La chemise est disposée dans un pot dont elle est séparée par un matériau à faible conduction thermique tel que le carbone. Une technique de dépôt sur un substrat, d'un film homogène d'un alliage métallique tel que Pb Sn par évaporation sous vide sous l'action d'un canon à électrons, est connu de par l'article paru dans l'IBM TDB, Vol. 14, N°10, mars 1972, p. 3131: «Homogeneous film evaporation of differing vapor pressure materials».

Afin d'atteindre les objectifs énumérés plus haut, l'équipement selon la présente invention présente les perfectionnements suivants: Le creuset est constitué par une chemise en tantale, dont la partie inférieure est celle d'un V, disposée dans un pot en cuivre et espacée de lui par une lame d'air, pour ralentir les échanges thermiques entre-eux. Les revendications 2–9 concernent des modes de réalisation préférés de l'équipement défini dans la revendication 1 et son application à la formation de plots de soudure sur des dispositifs semi-conducteurs. La chemise contient la source de matériau à évaporer: Pb-Sn ou Pn-In. Le faisceau d'électrons est focalisé sur le centre de la source. Le dispositif porte-substrats est constitué par un dôme à plusieurs étages, mobile en rotation, et associé à un écran amovible, qui est disposé entre la source et les substrats durant l'évaporation du plomb et retiré durant l'évaporation de l'étain. Une jauge à collecteur d'ions fournit l'indication du passage de l'évaporation du plomb à celle de l'étain.

La présente invention sera plus facilement comprise à l'aide de la description qui va suivre, faite en référence aux figures annexées à ce texte, qui représentent un mode de réalisation préféré de l'invention dans lesquelles:

La fig. 1 représente schématiquement l'équipement de dépôt par évaporation sous vide par canon à électrons conforme à la présente invention.

La fig. 2 représente l'évolution dans le temps du courant de sortie d'une jauge à collecteur d'ions qui met en évidence l'instant de la transition entre l'évaporation du plomb et celle de l'étain.

La fig. 3 représente les dispersions de compositions obtenues dans les films déposés selon qu'un écran de répartition est disposé fixe ou amovible dans l'enceinte à vide, pour différencier l'évaporation du plomb et de celle de l'étain.

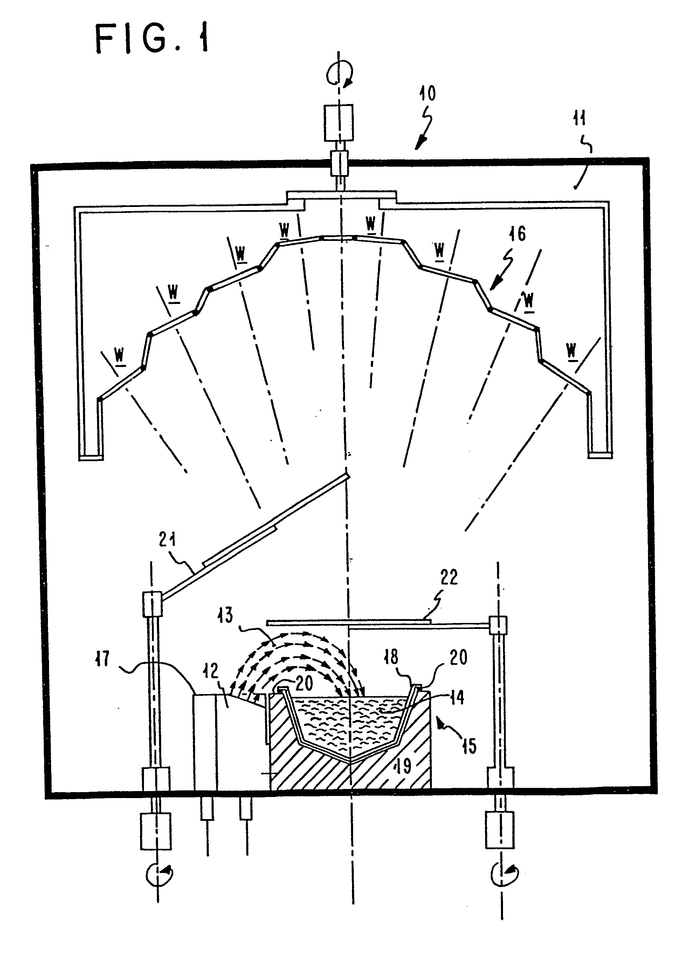

La figure 1 représente schématiquement l'équipement selon l'invention. L'équipement 10 comporte tout d'abord certains éléments classiques d'un équipement d'évaporation sous vide par canon à électrons: à savoir une enceinte à vide 11 montée dans un bâti (non représenté), tel celui du modèle A 1100 Q fabriqué par Leybold Heraeus. Un canon à électrons 12 de type ESU 14 qui génère et focalise le faisceau électronique 13 sur la source 14 à évaporer; cette dernière est contenue dans un creuset 15. Un dispositif porte-substrats 16, portant un nombre déterminé de tranches en silicium exposée selon une configuration désirée et les masques métalliques (non représentés) dont il a été fait mention ci-dessus. Il comporte enfin, une jauge à collecteur d'ions 17 par exemple du type LH 83–3215 qui permet habituellement le contrôle de la vitesse d'évaporation.

L'ensemble groupe de pompage primaire/pompe à diffusion d'huile qui a pour fonction de faire le vide dans l'enceinte n'a pas été représenté pas plus que les différents moyens de refroidissement de l'enceinte à vide, du creuset, etc..

Habituellement, le faisceau électronque vient frapper la source sur le bord du creuset, ce qui assure une meilleure tenue thermique du creuset grâce aux courants de convection qui se développent dans la source. En outre, le creuset est généralement constitué par un récipient de molybdène disposé légèrement incliné dans un pot de cuivre grâce à une cale. On peut admettre qu'un tel équipement classique est susceptible d'être utilisé pour faire des dépôts d'alliages métalliques tels que de l'aluminium-cuivre pour les configurations de conducteurs (épaisseur 2 microns) à la surface des microplaquettes, comportant des produits bipolaires. Cependant, son utilisation est, difficilement envisageable, d'une part pour réaliser des plots de soudure qui nécessitent des épaisseurs de 100 µm et des compositions et des volumes très contrôlés, et d'autre part dans des applications aux produits unipolaires, tels que des transistors à effet de champ.

Il est en effet une autre raison qui peut expliquer que les équipements de dépôt par évaporation sous vide par canon à électrons n'aient pas, apparemment été utilisés, à ce jour, pour la formation des plots de soudure. Cette technique est pourtant, bien maîtrisée et largement utilisée, en raison de sa simplicité d'emploi dans diverses industries pour le dépôt d'une grande variété de matériaux notamment des métaux ou des alliages de métaux. Il est bien connu qu'un faisceau d'électrons engendre des rayons X intenses et des électrons secondaires, qui irradient les substrats au cours du dépôt. Dans le cas des micro-plaquettes de circuits intégrés, dont le système métallurgique est généralement composé de conducteur en aluminium ou en aluminium cuivre, isolés les uns des autres passivés par des couches de bioxyde de silicium, la présence notamment de ces rayons X est susceptible de générer des défauts tant dans les couches isolantes $SiO_2$ que dans les interfaces Si-$SiO_2$. Ces défauts risquent de modifier les caractéristiques électriques des composants élémentaires intégrés dans le temps, surtout lorsqu'il s'agit de produits unipolaires tels que des transistors à effet de champ, et sont donc des facteurs potentiels de réduction de la fiabilité des microplaquettes, ce qui est évidemment inacceptable.

Malgré le réel préjugé technique qui découlait logiquement de ce phénomène non désirable d'irradiations aux rayons X, la demanderesse a procédé à diverses expérimentations qui ont mis en évidence: d'une part que le phénomène restait théorique et n'avait en fait aucune incidence pratique même sur les produits unipolaires, et d'autre part que les équipements conventionnels de dépôts par évaporation sous vide par canon d'électrons se révélaient inopérants pour la formation de tels plots de soudure.

Poursuivant ces expérimentations, la demanderesse a procédé aux observations et adaptations suivantes.

Une chemise 18, en tantale, présentant la forme générale d'un V, est disposée dans un pot en cuivre 19 refroidi par eau, de telle sorte qu'il existe un mince espace entre la chemise et le pot. En outre, la chemise repose sur le pot par l'intermédiaire d'un anneau de cuivre 20. Le tantale a été retenu après que différents matériaux aient été testés. Le molybdène se dissout facilement dans l'étain et après quelques cycles le complexe qui se forme entre les deux métaux, empêche la poursuite de l'évaporation.

Avec une chemise en carbone, l'étain ne mouille pas les parois et s'échappe de la zone oú est appliqué le faisceau, il ne peut donc être évaporé. On a d'abord montré qu'avec une chemise en tantale, les résultats sont satisfaisants en particulier parce que le tantale ne se dissout pas facilement dans l'étain.

En ce qui concerne la forme particulière de la chemise, il a été observé que cette forme originale en V permet l'évaporation de la totalité de la charge et non plus, comme avec les creusets classiques d'une petite portion seulement de la source. L'évaporation à fond de creuset supprime l'obligation de recharge du creuset. En outre, cette opération de recharge nécessite des déplacements fréquents du creuset, et donc provoque des variations dans la zone de focalisation du faisceau; il en résulte finalement une faible reproductibilité des vitesses d'évaporation.

Le volume de la chemise est typiquement de 200cm³. La charge à évaporer sera 2 kg environ de matériau choisi, par exemple du 95Pb-5Sn sous forme de pastilles de 15 ou 16,5g. L'espacement produit par la chemise, qui n'est pas disposée directement sur le pot de cuivre, s'est avéré très bénéfique et se combine avantageusement avec la présence de l'anneau de cuivre, qui assurant une surélévation de la chemise, limite également les échanges thermiques et permet d'améliorer de façon significative la reproductibilité des dépôts.

La focalisation du faisceau électronique 13 s'est également avérée être un point critique. Il a été montré qu'une distribution non uniforme de l'énergie sur la surface de la source, induisait des variations aléatoires dans les pressions de vapeur en différents points de la surface de la source en fusion et qu'il en résultait des écarts importants dans les vitesses d'évaporation. Différents essais ont montré qu'un faisceau électronique relativement fin (pour que la surface d'impact soit d'environ 2cm²) et focalisé au centre de la source, donnait les meilleurs résultats.

Le canon est alimenté avec une énergie de 6kW; en outre l'ouverture du faisceau est ajustée de façon à limiter les redépôts parasites sur les isolateurs, soit directement par évaporation, soit par déflexion ionique due aux champs magnétiques, produits par les bobines de commande de la déflexion du canon.

La jauge à collecteur d'ions 12 est un dispositif classique qui fonctionne sur le principe de l'ionisation des atomes évaporés sous l'action des champs électriques en recueillant l'émission d'électrons secondaires. Il a pour fonction habituelle de réguler la vitesse d'évaporation et donc l'épaisseur du dépôt en commandant l'énergie du canon à électrons; le courant recueilli en sortie étant proportionnel à la vitesse de dépôt.

Dans le présent équipement la jauge est utilisée de façon originale non pas pour réguler la vitesse d'évaporation et donc commander l'épaisseur du dépôt mais pour détecter le point de transition, entre la fin de l'évaporation du plomb et le début de celle de l'étain. En effet, la tension de vapeur de plomb est très largement inférieure à celle de l'étain, c'est donc le plomb qui est évaporé le premier (il en est de même avec l'indium).

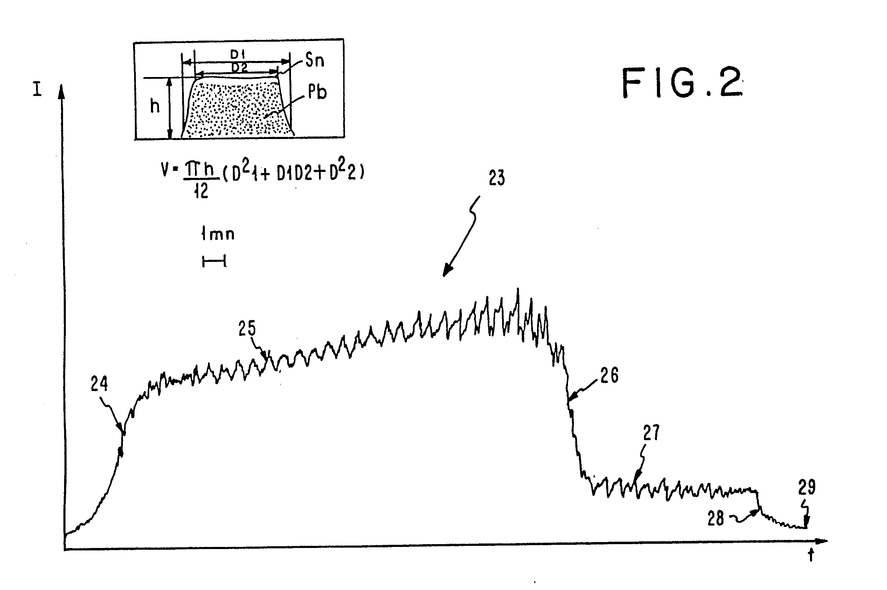

La figure 2, qui sera étudiée plus en détail, ci-après, montre la sortie en courant du dispositif qui met bien en évidence l'existence de deux transitions et permet donc de suivre et de contrôler l'évolution du procédé. L'encadré, montre les épaisseurs respectives du plomb et de l'étain déposés et le volume final du plot, pour qu'après l'étape de chauffage de la soudure, le plot présente bien la composition (par exemple 95Pb-5Sn) et le volume désirés.

Enfin, pour réaliser un équipement à haute capacité, comme on l'a écrit ci-dessus, on a remplacé la sole classique portetranches, plane et fixe, qui constitue habituellement le dispositif porte-tranches 16 dont il a été fait mention ci-dessus, par un dôme mobile à quatre étages dont la capacité totale peut être portée par exemple à 52 tranches de 82mm. En raison des différences d'éloignement entre chacun des étages et la source, qui causeraient des dépôts d'épaisseurs différentes, un écran amovible 21 dont le rôle sera explicité ci-après, doit être préférablement associé au dôme.

Cet écran dit de répartition a la forme d'une portion d'ellipse et il est disposé entre la source et les substrats pour compenser la directivité du cône d'évaporation. A défaut de cet écran, le matériau de la source est déposé en plus grandes quantités sur les tranches qui garnissent les étages supérieurs du dôme que sur celles des étages inférieurs.

On s'est aperçu que cet écran pouvait jouer un rôle important pour l'obtention de plots présentant des compositions constantes, dès lors qu'on procédait de la façon suivante: l'écran est mis en place durant toute l'évaporation du plomb et retiré est automatiquement dès que commence l'évaporation de l'étain qui fait suite à celle du plomb. Cet écran de répartition 21 doit être distingué du volet couvre source 22, d'usage classique mis en place durant la préchauffe.

Cette opération est effectuée automatiquement à partir des indications fournies par la jauge à collecteur d'ions. La figure 2 représente précisément l'évolution du courant de sortie de la jauge à collecteur d'ions 17 montrée sur la figure 1 en fonction de la durée du dépôt.

La courbe 23 comporte une première portion croissante 24, caractéristique de la mise en route ou préchauffe de l'évaporateur. La portion 25 débute à la fin de la préchauffe, cette portion pratiquement à courant constant, mesure la durée du dépôt de plomb; la transition 26 correspond à l'arrêt d'évaporation du plomb et le passage à l'évaporation de l'étain; la durée de cette dernière est mesurée par la portion 27. Une nouvelle transition 28 indique la fin d'évaporation de l'étain et la portion 29, l'arrêt de l'évaporateur.

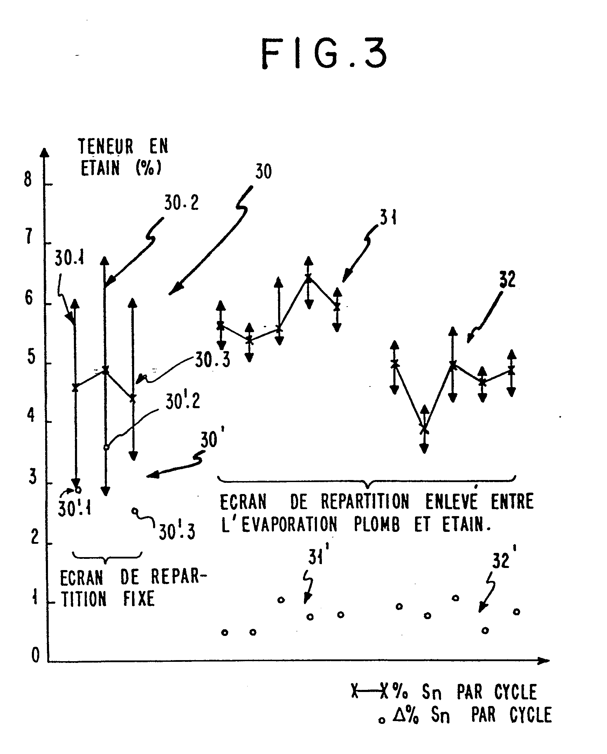

L'écran 21 sera donc retiré dès que la transition 26 sera mise en évidence par la jauge 17, tandis que l'évaporation sera arrêtée dès que la transition 28 sera détectée. De cette façon les dispersions dans les compositions de l'alliage 95Pb-5Sn ont été considérablement réduites ainsi que cela apparaît sur la figure 3.

Sur cette figure, on a représenté, les variation de la teneur en étain des billes obtenues selon que l'écran 21 était laissé en place pendant tout le processus d'évaporation ou retiré entre l'évaporation du plomb et celle de l'étain. Les courbes 30 montrent pour trois cycles de fabrication (30.1 à 30.3) les variations de la teneur en étain quand l'écran 21 est laissé pendant toute la durée de l'évaporation montrant les variations correspondantes différentielles entre les minima et maxima. La courbe 30.1 montre que la teneur en étain varie de 3 (valeur min.) à 6% (valeur max.). On voit que dans ce cas, les variations différentielles sont de l'ordre de 3%. Quand l'écran est retiré conformément à la présente invention (courbes 31 et 32) on se rend compte que les variations différentielles ne sont plus que de l'ordre de 0,5 à 1% (points 31' et 32').

Le procédé peut être résumé de la façon suivante:

La pression au départ du cycle est de l'ordre de $2,5 \times 10^{-3}$ Pa qui sera atteinte en 15mn au maximum. Le vide limite sera de $1,3 \times 10^{-5}$ Pa et le taux maximum d'hydrocarbure de 5%. La charge sera celle précédemment mentionnée: 2kg environ de 95Pb-5Sn, par exemple sous forme de pastille de 15g. L'alimentation du canon sera de 6kW avec la focalisation au centre de la zone avec une zone d'impact de 2cm² environ. Le dôme est du type à étages et comporte 52 tranches environ de 82mm aux emplacements référencés par W. Une rotation du dôme de 6tr/minute ± 3 tr/minute sera assurée durant toute la durée du dépôt. La source sera centrée par rapport à l'axe de rotation du dôme. Les distances du centre de la source au centre de chaque tranche seront:

58,4 cm pour l'étage bas   (No.1)
62,0 cm pour l'étage bas   (No.2)
67,3 cm pour l'étage bas   (No.3)
68,8 cm pour l'étage haut   (No.4)

Les parois de l'enceinte seront protégées par des chemises en acier inoxydable refroidies durant le cycle et réchauffées durant la ventilation et la mise à l'air de l'enceinte. Le vide sera cassé par un courant d'azote.

La mise en rotation du dôme et la mise sous tension du canon s'effectuent dès que le vide de $2,5 \times 10^{-3}$Pa est atteint.

La charge est préchauffée pendant environ 10mn. Cette étape est destinée à rendre la source liquide et à assurer son dégazage. Pendant la préchauffe le volet couvre source 22 est en place. A la fin de la préchauffe, on procède simultanément au retrait du volet 22 et au déplacement automatique de l'écran 21 qui est laissé en place pendant toute la durée de l'évaporation du plomb; cet écran positionné est à 200 mm environ du plan de la source; la fin de l'évaporation du plomb sera détectée par la transition 26 du signal fourni par la jauge, l'écran est alors retiré automatiquement et on passe à l'évaporation de l'étain; l'évaporation terminée le pompage se poursuit 5 minutes, puis une ventilation à l'azote est effectuée pendant 15mn. La haute tension du canon est coupée et la rotation du dôme stoppée pendant cette ventilation.

Le temps de cycle est d'environ 105mn pour le dépôt Pb/Sn. On a noté les chiffres suivants relatifs aux variations d'épaisseur:

tolérance sur un cycle     114 ± 7μm
tolérance de cycle à cycle 114 ± 10μm

La durée de vie des creusets est d'environ 30 cycles.

Les avantages résultant de la mise en œuvre de l'équipement selon l'invention par rapport à l'utilisation des équipements standards d'évaporation sous vide par induction HF sont les suivants.

Un gain en rendement, c'est-à-dire la diminution du taux de rejet des microplaquettes de 0,4% à 0,2%.

Un gain en productivité en raison de la diminution des temps de cycle de l'ordre de 30% (environ 105mn comparées à 140mn environ) et possibilité d'une automation totale.

Un gain économique substantiel: la durée de vie des creusets est multipliée par trois et outre la suppression d'un générateur HF d'induction, il y a également un gain de place important. Il apparaît donc que la formation des plots de soudure par évaporation sous vide par canon à électrons est une technique d'avenir car elle réduit considérablement à la fois les problèmes de couplage et les phénomènes de miniprojection mentionnés ci-dessus. En ce qui concerne ce dernier phénomène les composés oxydés emmagasinant des charges négatives par piégeage d'électrons en provenance du faisceau, sont ainsi repoussés du point d'impact du faisceau, et donc de la surface de la source.

**Revendications**

1. Equipement de dépôt par évaporation sous vide par canon à électrons du genre comportant: une enceinte à vide (11), un dispositif porte-substrats (16), un creuset présentant la forme générale d'un V (15) contenant la source (14) du matériau à évaporer disposé dans un pot (19) et séparé de lui par un matériau à faible conduction thermique, et un canon à électrons (17) caractérisé en ce que le creuset est constitué par une chemise (18) en tantale; en ce que la partie inférieure de cette chemise est en forme de V pour permettre l'évaporation à fond de creuset; et en ce que ledit pot est en cuivre et ledit matériau à faible conduction thermique est l'air.

2. Equipement de dépôt par évaporation sous vide à canon à électrons selon la revendication 1 caractérisé en ce que la chemise (18) est surélevée par rapport au pot (19) par la présence d'un anneau de cuivre (20).

3. Equipement de dépôt par évaporation sous vide à canon à électrons selon l'une des revendications 1 ou 2 caractérisé en ce qu'il est agencé de façon à ce que le faisceau d'électrons émis par ledit canon à électrons (17) soit focalisé sur le centre de la source.

4. Equipement de dépôt par évaporation sous vide à canon à électrons selon l'une des revendications 1, 2 ou 3 caractérisé en ce que lesdits substrats sont des tranches de silicium masquées selon une configuration désirée pour exposer les emplacements destinés à recevoir le matériau à déposer.

5. Equipement de dépôt par évaporation sous vide par canon à électrons selon la revendication 4 caractérisé en ce que ledit matériau à évaporer est un alliage de soudure choisi dans le groupe Pb-Sn et Pb-In.

6. Equipement de dépôt par évaporation sous vide par canon à électrons selon la revendication 5 caractérisé en ce qu'il comporte en outre une jauge à collecteur d'ions (17) dont le courant de sortie indique la durée du dépôt du plomb (25), puis la transition (26) vers l'évaporation de l'étain Sn (ou In), et la durée de cette dernière (27).

7. Equipement de dépôt par évaporation sous vide par canon à électrons selon la revendication 6, caractérisé en ce que le dispositif (16) qui porte les tranches en silicium est formé par un dôme à plusieurs étages et mobile en rotation.

8. Equipement de dépôt par évaporation sous vide à canon à électrons selon la revendication 7, caractérisé en ce qu'il comporte en outre un écran amovible (21), en forme de portion d'ellipse qui est disposé entre la source et les tranches en silicium pendant l'évaporation du plomb, puis retiré pendant l'évaporation de l'étain Sn (ou In), son déplacement étant commandé à partir de la transition (26) élaborée par la jauge à collecteur d'ions.

9. Application de l'équipement de dépôt selon l'une des revendications 1 à 8 à la formation de plots de soudure sur des dispositifs semi-conducteurs.

**Patentansprüche**

1. Ausrüstung zum Auftragen durch Vakuumverdampfung mit einer Vakuumkammer (11), einer Substrathaltevorrichtung (14), einem Schmelztiegel, der die allgemeine Form eines V aufweist (15) und die Quelle (14) des zu verdampfenden Werkstoffes enthält, der in einem Topf (19) angeordnet und von ihm durch einen Werkstoff mit geringer Wärmeleitfähigkeit getrennt ist, und eine Elektronenstrahlvorrichtung (17), dadurch gekennzeichnet, dass der Schmelztiegel aus einem Tantalmantel (18) besteht, und dadurch, dass der innere Teil dieses Mantels V-förmig ist, um die Verdampfung im Boden des Schmelztiegels zu gestatten; und dadurch, dass der besagte Topf aus Kupfer und das besagte Material mit geringer Wärmeleitfähigkeit Luft ist.

2. Ausrüstung zum Auftragen durch Vakuumverdunstung mit Elektronenstrahlvorrichtung gemäss Anspruch 1, dadurch gekennzeichnet, dass der Mantel (18) gegenüber dem Topf (19) durch einen vorhandenen Kupferring (20) überhöht ist.

3. Ausrüstung zum Auftragen durch Verdampfung unter Vakuum mit Elektronenstrahlvorrichtung gemäss einem der Ansprüche 1 oder 2, dadurch gekennzeichnet, dass sie so angeordnet ist, dass der von besagter Elektronenstrahlvorrichtung (17) ausgesandte Elektronenstrahl auf den Mittelpunkt der Quelle gebündelt ist.

4. Ausrüstung zum Auftragen durch Verdampfung unter Vakuum mit Elektronenstrahlvorrichtung gemäss einem der Ansprüche 1 oder 2, dadurch gekennzeichnet, dass besagte Substrate Siliziumscheiben sind, die nach einer gewünschten Konfiguration verdeckt sind, um die für die Aufnahme des aufzutragenden Werkstoffs bestimmten Stellen auszusetzen.

5. Ausrüstung zum Auftragen durch Verdampfung unter Vakuum mit Elektronenstrahlvorrichtung gemäss Anspruch 4, dadurch gekennzeichnet, dass das besagte auszudampfende Material eine Schweisslotlegierung ist, aus der Gruppe Pb-Sn und Pb-In gewählt.

6. Ausrüstung zum Auftragen durch Verdampfung unter Vakuum mit Elektronenstrahlvorrichtung gemäss Anspruch 5, dadurch gekennzeichnet, dass sie ausserdem eine Ionensammelmessvorrichtung (17) enthält, deren Ausgangsstrom die Dauer anzeigt, in der Blei (25) aufgetragen wird, dann den Übergang (26) zum Verdampfen von Zinn Sn (oder In), und die Dauer dieser letzteren Verdampfung (27).

7. Ausrüstung zum Auftragen durch Verdampfung unter Vakuum mit Elektronenstrahlvorrichtung gemäss Anspruch 6, dadurch gekennzeichnet, dass die Vorrichtung (16), welche die Siliziumscheiben trägt, aus einer mehrstufigen drehbaren Kuppel besteht.

8. Ausrüstung zum Auftragen durch Verdampfung unter Vakuum mit Elektronenstrahlvorrichtung gemäss Anspruch 7, dadurch gekennzeichnet, dass sie ausserdem einen abnehmbaren Schirm (21) enthält, in Form eines Ellipsenteils, das während der Verdampfung des Bleis zwischen der Quelle und den Siliziumscheiben angeordnet ist und dann während der Verdampfung des Zinns Sn (oder In) entfernt wird, wobei die Bewegung durch vom Übergang (26) aus gesteuert wird, der von der Messvorrichtung mit Ionenkollektor bewirkt wird.

9. Anwendung der Auftragsausrüstung gemäss einem der Ansprüche 1 bis 8 für die Herstellung von Lötpunkten auf Halbleitervorrichtungen.

## Claims

1. Electron gun equipment for vacuum deposition of the type which includes a vacuum chamber (11), a substrate carrier (16), a generally V shaped crucible (15) containing a source (14) of material to be evaporated and provided in a pot (19) and separated therefrom by refractory material, and an electron gun (17), characterized in that the crucible is comprised of a liner (18) made of tantalum, in that the lower part of said liner is V shaped to allow said material to evaporate from the bottom of crucible (15), and in that said pot is made of copper and said refractory material is air.

2. Electron gun equipment according to claim 1, characterized in that a copper ring (20) makes liner (18) to protude from the copper pot.

3. Electron gun equipment according to claim 1 or claim 2, characterized in that it is arranged so that the electron beam emitted by said electron gun (17) is focused onto the center of the source.

4. Electron gun equipment according to claim 1, 2 or 3, characterized in that said substrates are silicon wafers masked according to a desired configuration in order to expose the locations which will receive material to be deposited.

5. Electron gun equipment according to claim 4, characterized in that said material to be evaporated is a solder alloy chosen in the Pb-Sn and Pb-In group.

6. Electron gun equipment according to claim 5, characterized in that it further includes a ion collector gauge (17) the output current of which is indicative of lead deposition time length (25), and then, of transition (26) to tin Sn (or In) evaporation, and of time length (27) of said tin evaporation.

7. Electron gun equipment according to claim 6, characterized in that device (16) which carries the silicon wafers consists in a rotatably mounted dome with several tiers.

8. Electron gun equipment according to claim 7, characterized in that it further includes a removable shield (21) shaped as a portion of an ellipse provided between the source and the silicon wafers during lead evaporation and which is removed during tin Sn (or In) evaporation, its motion being controlled by transition (26) monitored by the ion collector gauge.

9. Application of the electron gun equipment according to any one of claims 1 to 8 to the provision of weld studs onto semiconducting devices.

# FIG. 1

FIG.2

$V = \dfrac{\pi h}{12}(D^2_1 + D1D2 + D^2_2)$

# FIG.3

TENEUR EN ETAIN (%)

30
30.2
30.1
30.3
30'.2
30'
30'.1
30'.3

31
32

ECRAN DE REPARTITION ENLEVÉ ENTRE L'EVAPORATION PLOMB ET ETAIN.

ECRAN DE REPAR- TITION FIXE

31'
32'

X——X % Sn PAR CYCLE
○ Δ % Sn PAR CYCLE

13